# EUROPEAN PATENT APPLICATION

(11) **EP 4 321 903 A1**
(43) Date of publication of application: **14.02.2024**
(21) Application number: 21935874.4
(22) Date of filing: 15.12.2021
(51) Int. Cl.: G01S 17/48, G01S 7/484

(54) **SOLID-STATE LASER RADAR AND METHOD FOR DETECTING BY USING SAME**

(30) Priority: 08.04.2021 CN 202110378462; 08.04.2021 CN 202120714418 U
(71) Applicant: Hesai Technology Co., Ltd., Shanghai 201821 (CN)
(72) Inventor: LIU, Hao, Shanghai 201821 (CN); ZHU, Xuezhou, Shanghai 201821 (CN); XU, Sen, Shanghai 201821 (CN); LIU, Xugang, Shanghai 201821 (CN); XIANG, Shaoqing, Shanghai 201821 (CN)
(74) Representative: Appelt, Christian W.
(86) International application number: PCT/CN2021/138327
(87) International publication number: WO 2022/213658

(57) **Abstract**

A solid-state laser radar (100), including: a plurality of emission modules (110), each emission module (110) including at least one light-emitting unit (111), and the light-emitting unit (111) including a plurality of lasers configured to emit detection beams at the same time; and a receiving module (120), including at least one detection unit (121), the detection unit (121) including a plurality of photodetectors configured to receive echos, reflected by a target object, of the detection beams, the plurality of emission modules (110) are disposed around the receiving module (120), the light-emitting units (111) of the plurality of emission modules (110) are located on a same plane, and one detection unit (121) is configured to receive echos, reflected by the target object, of the detection beams emitted by the light-emitting units (111) of the plurality of emission modules (110). For a set range of field angles, the lengths of the linear array light-emitting units (111) emitting light at the same time are greatly reduced by providing the plurality of emission modules (110), thereby greatly reducing the light-emitting non-uniformity of the light-emitting units (111), reducing a ranging error of the solid-state laser radar (100) within the set field angles, and improving the ranging performanceLiDAR.

## Description

### TECHNICAL FIELD

The present disclosure generally relates to the technical field of laser detection, in particular to a solid-state LiDAR and a method for detection using the same.

### BACKGROUND

A LiDAR can obtain information such as a distance from an object, a speed of the object or realize object imaging with high precision and high accuracy, playing an important role in fields such as surveying and mapping, navigation, etc. LiDARs can be typically divided into two categories: mechanical LiDARs and solid-state LiDARs. A mechanical LiDAR uses a mechanical rotating components to achieve beams scanning, which enables large-angle scanning, but it is difficult to assemble and the scanning frequency is low. The current implementations of solid-state LiDAR include a micro-electromechanical system, an area array solid-state radar and an optical phased array technology.

The light source of an area array solid-state LiDAR is usually a high-density vertical cavity surface-emitting laser (VCSEL) array, and multiple lasers are connected in parallel to form a light emitting unit, which is simultaneously driven to emit light. The length of the light emitting unit is extremely long, the width is extremely narrow, and the aspect ratio is considerably high, which leads to a voltage drop due to the resistance and parasitic inductance of the drive line under the condition of high current and high frequency drive. As such, in the propagation direction of the driving signal, the driving currents of the multiple lasers are gradually reduced, and the luminances are also gradually reduced. As a result, within the field of view of the LiDAR, the intensity distribution of the detection light in the extention direction of the light emitting unit is uneven, thereby affecting the distance measurement capability and detection precision of the solid-state LiDAR.

The content in the background section is only the technology known to the discloser, and does not necessarily represent the existing technology in the field.

### SUMMARY

In view of at least one defects in the existing technology, the present disclosure provides a solid-state LiDAR, including:
a plurality of transmitting modules, each of which includes at least one light emitting unit, the light emitting unit including a plurality of lasers configured to simultaneously emit detection beams; and
a receiving module including at least one detection unit, the detection unit including a plurality of photodetectors configured to receive echos of the detection beams reflected off an object,
wherein the plurality of transmitting modules are arranged around the receiving module, the light emitting units of the plurality of transmitting modules are located on a same plane, and one detection unit is configured to receive echos of the detection beams emitted from the light emitting units of the plurality of transmitting modules and reflected off the obj ect.

According to an aspect of the present disclosure, the plurality of lasers of the light emitting unit are arranged along a strip shape, and the transmitting module includes a plurality of light emitting units that are arranged in a direction perpendicular to an extention direction of the strip shape.

According to an aspect of the present disclosure, the transmitting module is arranged on both sides of the receiving module, and the numbers of transmitting modules on both sides of the receiving module are the same or different.

According to an aspect of the present disclosure, each of the transmitting modules includes a plurality of light emitting units of the same number, and light emitting units corresponding to the same detection unit are located on a same straight line.

According to an aspect of the present disclosure, fields of view corresponding to a plurality of light emitting units located on the same straight line partially overlap.

According to an aspect of the present disclosure, the solid-state LiDAR includes two transmitting modules, and the two transmitting modules are located on both sides of the receiving module.

According to an aspect of the present disclosure, the light emitting unit includes a VCSEL array, and the detection unit includes a SPAD array.

According to an aspect of the present disclosure, a blindness-filling laser is provided on a side of the light emitting unit away from the receiving module in the extention direction of the strip shape, a detection range of the blindness-filling laser is different from that of the light emitting unit, and an echo of detection light emitted by the blindness-filling laser and reflected off the object is receivable by the detection unit corresponding to the light emitting unit.

According to an aspect of the present disclosure, the transmitting module further includes an electrode unit, the electrode unit is electrically connected to the plurality of lasers of the light emitting unit, and the electrode unit includes a plurality of driving terminals, through which driving signals are simultaneously loaded to the plurality of lasers of the light emitting unit.

According to an aspect of the present disclosure, the electrode unit further includes pads disposed at both ends of the light emitting unit in the extention direction of the strip shape, and the pads are used to load the driving signals.

According to an aspect of the present disclosure, the transmitting module further includes a transmitting optical component, at least one light emitting unit of the transmitting module is located on a focal plane of the transmitting optical component, and the transmitting optical component is configured to receive the detection beams emitted by the at least one light emitting unit, shape the detection beams and then emit the shaped detection beams to an object space.

According to an aspect of the present disclosure, the transmitting optical components of the plurality of transmitting modules are identical.

According to an aspect of the present disclosure, the transmitting module further includes a microlens array disposed downstream of optical paths of the plurality of lasers.

According to an aspect of the present disclosure, the receiving module further includes:
a receiving optical component configured to receive and converge echos of the detection beams of a first band emitted by the solid-state LiDAR and reflected off the object, and beams of a second band, wherein the second band does not include the first band;
a light splitting unit arranged downstream of an optical path of the receiving optical component and configured to separate optical paths of the reflection echos of the detection beams from optical paths of the beams of the second band;
the at least one detection unit arranged downstream of an optical path of the light splitting unit and configured to receive the reflection echos of the detection beams from the light splitting unit and convert the reflection echos of the detection beams into electrical signals; and
at least one imaging unit arranged downstream of the optical path of the light splitting unit and configured to receive the beams of the second band from the light splitting unit and form an image.

According to an aspect of the present disclosure, the plurality of photodetectors of each detection unit are simultaneously activated to receive the reflection echos, each imaging unit includes a plurality of image sensors, the plurality of image sensors of the imaging unit are simultaneously activated to receive the beams of the second band and form an image, and a detection unit and an imaging unit corresponding to the same field of view are simultaneously activated for detection and exposure.

According to an aspect of the present disclosure, the light splitting unit includes a light-splitting transflective mirror, such that the reflection echos of the detection beams are reflected, and the beams of the second band are transmitted, or alternatively, the reflection echos of the detection beams are transmitted, and the beams of the second band are reflected.

The present disclosure also provides a method for detection using the solid-state LiDAR described above, including:
emitting, by the light emitting units of the transmitting modules, detection beams for detection of an object;
receiving, by the detection unit of the receiving module, echos of the detection beams reflected off the object; and
determining a distance from the object based on a time at which the detection beams are emitted and a time at which the echos are received.

According to an aspect of the present disclosure, the solid-state LiDAR includes two transmitting modules, the two transmitting modules are located on both sides of the receiving module, the two transmitting modules each include a plurality of light emitting units of the same number, and light emitting units corresponding to the same detection unit are located on the same straight line, and the method further includes:
emitting light simultaneously or alternately by two light emitting units corresponding to the same detection unit.

According to an aspect of the present disclosure, the plurality of lasers of the light emitting unit are arranged in a strip shape, a blindness-filling laser is provided on a side of the light emitting unit away from the receiving module in the extention direction of the strip shape, a detection range of the blindness-filling laser is different from that of the light emitting unit, and an echo of detection light emitted by the blindness-filling laser and reflected off the object is receivable by the detection unit corresponding to the light emitting unit; and the method further includes: emitting light simultaneously by the blindness-filling laser and the light emitting unit.

According to an aspect of the present disclosure, the plurality of lasers of the light emitting unit are arranged in a strip shape, the transmitting module further includes an electrode unit electrically connected to the plurality of lasers of the light emitting unit, and the electrode unit includes a plurality of driving terminals; and the method further includes:
simultaneously loading driving signals to the plurality of lasers of the light emitting unit through the plurality of driving terminals.

According to an aspect of the present disclosure, the electrode unit further includes pads provided at both ends of the light emitting unit in an extension direction of the strip shape, and the method further including:
loading the driving signals via the pads.

According to an aspect of the present disclosure, the receiving module further includes: a receiving optical component; a light splitting unit arranged downstream of an optical path of the receiving optical component; the at least one detection unit arranged downstream of an optical path of the light splitting unit; and at least one imaging unit arranged downstream of the optical path of the light splitting unit; and the method further includes:
receiving and converging, by the receiving optical component, echos of the detection beams of a first band emitted by the solid-state LiDAR and reflected off the object, and beams of a second band, wherein the second band does not include the first band;
separating, by the light splitting unit, optical paths of reflection echos of the detection beams from optical paths of the beams of the second band;
receiving the reflection echos of the detection beams from the light splitting unit and converting the reflection echos of the detection beams into electrical signals by the at least one detection unit; and
receiving the beams of the second band from the light splitting unit and forming an image by the at least one imaging unit.

The preferred embodiment of the present disclosure provides a solid-state LiDAR. For a set range of field of view, the lengths of the linear light emitting units that emit light at the same time are greatly reduced by setting a plurality of transmitting modules, thereby greatly reducing the unevenness of light emission of the light emitting units, reducing the ranging error of the solid-state LiDAR within the set field of view, and improving the ranging performance.

In the preferred embodiments of the present disclosure, the number of lasers emitting light at the same time is reduced, the emission power of a single light emitting unit is decreased, the heat dissipation of the emission end can be reduced, and the temperature fluctuation can be lowered.

In a preferred embodiments of the present disclosure, when the light emitting units corresponding to multiple transmitting modules do not emit light at the same time, the emission power of a single light emission can be reduced, which is beneficial to the safety of human eyes. On the premise of meeting the safety requirements of human eyes, since the number of lasers emitting light at the same time is reduced, the laser power can be increased, the detection optical power can be improved, and the ranging capability of the LiDAR can be enhanced.

In a preferred embodiments of the present disclosure, after the detection light emitted by multiple transmitting modules is shaped and emerges, there is a certain overlapping area in the central field of view, which can increase the detection accuracy of the central area.

In a preferred embodiments of the present disclosure, the lengths of the linear light emitting units in some of the transmitting modules can be appropriately extended, thereby effectively reducing the blind area of the solid-state LiDAR. No special design is required for the laser area array, and thus the complexity of design and process is not increased.

### BRIEF DESCRIPTION OF THE DRAWINGS

The accompanying drawings are provided to facilitate a further understanding of the present disclosure, constitute a part of the description, and are used together with the embodiments of the present disclosure to explain the present disclosure without constituting a limitation to the present disclosure. In the drawings:
FIG. 1 schematically shows a solid-state LiDAR in the existing technology;
FIG. 2 schematically shows a schematic diagram of a partial surface structure of a top-emitting vertical-cavity surface-emitting laser (VCSEL) area array light source;
FIG. 3 schematically shows an uneven light emission of a row of parallel lasers;
FIG. 4A schematically shows a side view of a solid-state LiDAR according to a preferred embodiment of the present disclosure;
FIG. 4B schematically shows a front view of a solid-state LiDAR according to a preferred embodiment of the present disclosure;
FIG. 5A schematically shows a side view of a solid-state LiDAR according to a preferred embodiment of the present disclosure;
FIG. 5B schematically shows a front view of a solid-state LiDAR according to a preferred embodiment of the present disclosure;
FIG. 6A schematically shows a solid-state LiDAR that scans row by row in the vertical direction according to a preferred embodiment of the present disclosure;
FIG. 6B schematically shows a solid-state LiDAR that scans column by column in the horizontal direction according to a preferred embodiment of the present disclosure;
FIG. 7 schematically shows the field of view of a solid-state LiDAR according to a preferred embodiment of the present disclosure;
FIG. 8 schematically shows a formation of a blind area of a paraxial LiDAR;
FIG. 9 schematically shows a schematic diagram of an optical path of a blindness-filling laser according to a preferred embodiment of the present disclosure;
FIG. 10 schematically shows a position of a blindness-filling laser on a linear light emitting unit according to a preferred embodiment of the present disclosure;
FIG. 11 schematically shows setting of a bidirectional drive for a linear light emitting unit according to a preferred embodiment of the present disclosure;
FIG. 12 schematically shows an integration of a laser array and a microlens array according to a preferred embodiment of the present disclosure;
FIG. 13 schematically shows a receiving module according to a preferred embodiment of the present disclosure;
FIG. 14 schematically shows a receiving module according to a preferred embodiment of the present disclosure;
FIG. 15 schematically shows a solid-state LiDAR according to a preferred embodiment of the present disclosure; and
FIG. 16 shows a detection method according to a preferred embodiment of the present disclosure.

### DETAILED DESCRIPTION

In the following, only some exemplary embodiments are briefly described. As those skilled in the art will recognize, the described embodiments may be modified in various different ways without departing from the spirit or scope of the present disclosure. Accordingly, the drawings and descriptions are to be regarded as illustrative and not restrictive in nature.

In the description of the present disclosure, it needs to be understood that the orientation or position relations denoted by such terms as "central" "longitudinal" "latitudinal" "length" "width" "thickness" "above" "below" "front" "rear" "left" "right" "vertical" "horizontal" "top" "bottom" "inside" "outside" "clockwise" "counterclockwise" and the like are based on the orientation or position relations as shown in the accompanying drawings, and are used only for the purpose of facilitating description of the present disclosure and simplification of the description, instead of indicating or suggesting that the denoted devices or elements must be oriented specifically, or configured or operated in a specific orientation. Thus, such terms should not be construed to limit the present disclosure. In addition, such terms as "first" and "second" are only used for the purpose of description, rather than indicating or suggesting relative importance or implicitly indicating the number of the denoted technical features. Accordingly, features defined with "first" and "second" may, expressly or implicitly, include one or more of the features. In the description of the present disclosure, "plurality" means two or more, unless otherwise defined explicitly and specifically.

In the description of the present disclosure, it needs to be noted that, unless otherwise specified and defined explicitly, such terms as "installation" "coupling" and "connection" should be broadly understood, for example, it can be a fixed connection, a detachable connection, or an integral connection; it can be a mechanical connection, an electrical connection, or a intercommunication; it can be a direct connection, or an indirect connection via an intermediary medium; it can refer to internal communication between two elements or interaction between two elements. For those skilled in the art, the specific meanings of such terms herein can be construed in light of the specific circumstances.

Herein, unless otherwise specified and defined explicitly, if a first feature is "on" or "beneath" a second feature, this may cover direct contact between the first and second features, or contact via another feature therebetween, other than the direct contact. Furthermore, if a first feature is "on", "above", or "over" a second feature, this may cover the case that the first feature is right above or obliquely above the second feature, or just indicate that the level of the first feature is higher than that of the second feature. If a first feature is "beneath", "below", or "under" a second feature, this may cover the case that the first feature is right below or obliquely below the second feature, or just indicate that the level of the first feature is lower than that of the second feature.

The disclosure below provides many different embodiments or examples so as to realize different structures described herein. In order to simplify the disclosure herein, the following will give the description of the parts and arrangements embodied in specific examples. Of course, they are only for the exemplary purpose, not intended to limit the present disclosure. Besides, the present disclosure may repeat a reference number and/or reference letter in different examples, and such repeat is for the purpose of simplification and clarity, which does not represent any relation among various embodiments and/or arrangements as discussed. In addition, the present disclosure provides examples of various specific processes and materials, but those skilled in the art can also be aware of application of other processes and/or use of other materials.

The embodiments of the present disclosure will be described below in conjunction with the accompanying drawings. It should be understood that the embodiments described herein are only used to illustrate and explain the present disclosure, and are not intended to limit the present disclosure.

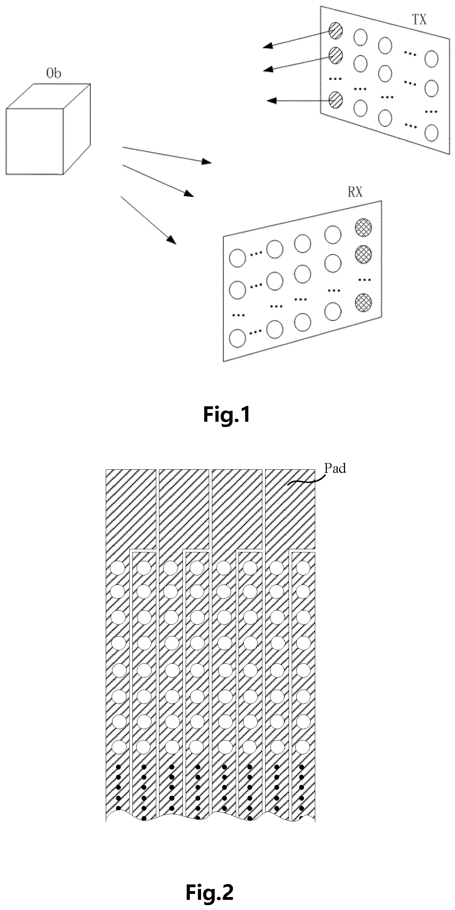

The transceiver structure and operation principle of the area array solid-state LiDAR are shown in FIG. 1. The transmitting module TX includes a laser array, and the receiving module RX includes a detector array. The laser array and the detector array are respectively arranged in focal planes of the transmitting lens group and the receiving lens group (not shown). The laser array emit detection beams to detect the object (OB), and the echo beams of the detection beams reflected off the object are received by the detector array. Optical signals are converted into electrical signals, then time conversion and histogram processing are carried out, and finally the distance information is obtained, which is sent to a monitoring system to form a point cloud image.

As one of the detection methods of the area array solid-state LiDAR, the laser array of the transmitting module is simultaneously driven to emit detection light covering the detection range, and the detector array of the receiving module is activated to receive echo signals.

As one of the detection methods of the area array solid-state LiDAR, the laser array of the transmitting module and the detector array of the receiving module can be grouped to emit light/detect in sequence. As shown in FIG. 1, each column of lasers is activated simultaneously as a light emitting unit, and each column of detectors is simultaneously activated as a detection unit. At time 11, the first column of lasers emits light, and the corresponding first column of detectors is activated for echo signal detection; at time t2, the second column of lasers emits light, and the corresponding second column of detectors is activated for echo signal detection, and so on, thereby reducing crosstalk caused by the simultaneous emission of all lasers for detection. Grouping may be performed by row, by sub-array, or so on. Each group of lasers emit light at the same time, and the corresponding group of detectors are activated at the same time for echo signal detection. The grouping are not limited to the above-mentioned manners.

A light source of a large-scale area array solid-state LiDAR is a high-density laser array. This array can make full use of the advantages of vertical cavity surface-emitting lasers that are easy to integrate on a large scale plane compared with edge-emitting lasers. Packaging, assembly complexity and cost are reduced while increasing the power density.

In an implementation, the laser is a vertical-cavity surface-emitting laser (VCSEL), and the detector is a single photon avalanche diode (SPAD).

FIG. 2 shows a schematic diagram of a partial surface structure of a light source of a top-emitting vertical-cavity surface-emitting laser (VCSEL) area array. The VCSELs in FIG. 2 are arranged in a matrix and designed as a column addressing structure. That is, each column of VCSELs is used as a light emitting unit of the transmitting module TX in FIG. 1, and the anode contact metals of each column of VCSELs are interconnected through the interconnection metal layer. The end of the interconnection metal layer is used as a bonding pad (marked in FIG. 2), and is connected to a driver chip through a metal bonding wire. The VCSELs in the same column are stimulated to emit light based on the same driving signal (from the driver circuit on the driver chip). To increase the current conduction area and reduce the resistance, the pad area is relatively large, and the width is about twice the width of the light emitting unit. The pad of an adjacent linear column is disposed on the lower edge of the area array (not shown), and is symmetrical to the upper edge structure as shown in FIG. 2.

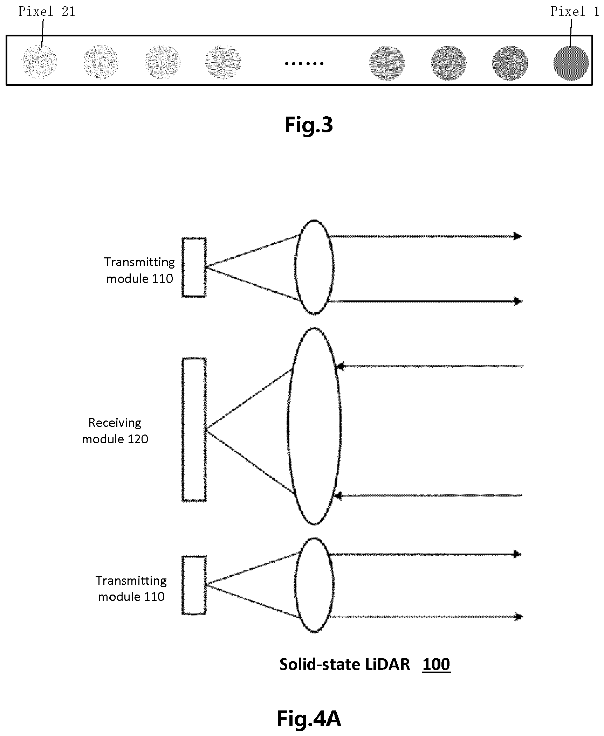

The light source of the vertical-cavity surface-emitting laser (VCSEL) area array shown in FIG. 2 realizes the high-density integration required for a large light-emitting area, but the ensuing problem is that each column of lasers in parallel (that is, a light emitting unit) is very long in length, very narrow in width, and has a very high aspect ratio, which leads to a voltage drop due to the resistance and parasitic inductance on the metal layer under the condition of high current and high frequency drive, and this results in the gradual decrease of the bias voltages of the same column of lasers, and thus decreasing the luminances gradually. As shown in FIG. 3, pixel-1 is the laser closest to the pad, and pixel-21 is the laser farthest from the pad. Due to the voltage drop caused by the resistance and parasitic inductance on the metal layer, the luminances of respective lasers are different. The luminance of pixel-21 is significantly lower than that of pixel-1.

In the application of area array solid-state LiDAR, different luminous intensities of multiple lasers of one light emitting unit will result in different ranging capabilities within the field of view corresponding to the light emitting unit, wherein a laser with a lower luminous intensity limits the ranging capability of the LiDAR, causing the distortion of the point cloud image, which reduces the detection precision of the LiDAR.

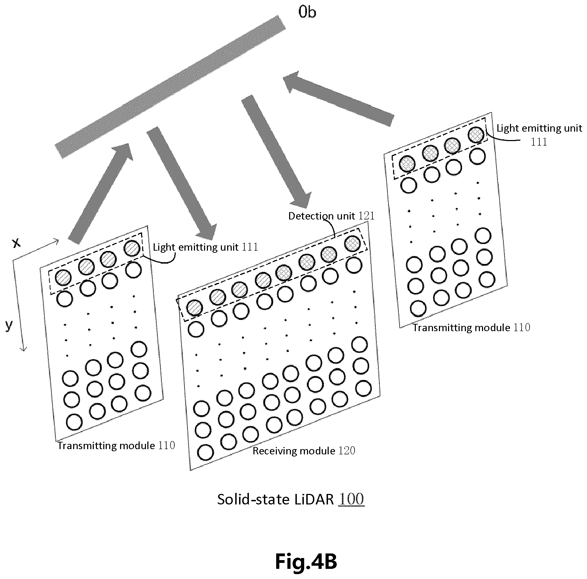

In order to solve the problem of the uneven luminous intensity of the linear light emitting unit in the area array solid-state LiDAR, as shown in FIG. 4A, the present disclosure provides a solid-state LiDAR 100 including multiple transmitting modules 110 and a receiving modules 120. As shown in FIG. 4B (FIG. 4A is a side view of the solid-state LiDAR 100, and FIG. 4B is a front view tilted at a certain angle), each transmitting module 110 includes at least one light emitting unit 111, and the light emitting unit 111 includes a plurality of lasers configured to simultaneously emit detection beams. The receiving module 120 includes at least one detection unit 121, and the detection unit 121 includes a plurality of photodetectors configured to receive echos of the detection beams reflected off the object.

As shown in FIG. 4A, multiple transmitting modules 110 are arranged around the receiving module 120, the light emitting units 111 of the multiple transmitting modules 110 are located on the same plane, and one detection unit 121 is configured to receive the echos of the detection beams emitted by the emitting units 111 of the multiple transmitting modules 110 and reflected off the object. As shown in FIG. 4B, preferably, one detection unit 121 corresponds to one light emitting unit 111 in each transmitting module 110, and the detection unit 121 is configured to receive the reflection echos of detection beams emitted by the corresponding multiple light emitting units 111.

According to a preferred embodiment of the present disclosure, the light emitting unit 111 of the solid-state LiDAR 100 includes a VCSEL linear column, and the detection unit 121 includes a SPAD linear column. As shown in FIG. 4A and FIG. 4B, two VCSEL area arrays are arranged symmetrically on both sides of the SPAD area array. Each row of VCSEL linear columns is simultaneously activated as one light emitting unit, and one row of SPAD linear columns is correspondingly divided into two parts according to the set positions of the two transmitting modules 110. As shown in FIG. 4B, one half of the SPADs indicated by oblique hatching serves as a detection subunit, corresponding to the same field of view as the light emitting unit, indicated by the oblique hatching, of the transmitting module 110 on the left in the figure, and receive the echo of the detection light emitted by one light emitting unit of the transmitting module 110 on the left in the figure and reflected off the object. The other half of the SPADs in the row indicated by the square hatching serves as another detection subunit, corresponding to the same field of view as the light emitting unit, indicated by the square hatching, of the transmission module 110 on the right side of the figure, and receive the echo of the detection light emitted by one light emitting unit of the transmitting module 110 on the right in the figure and reflected off the object.

The detection method of the solid-state LiDAR 100 of the present disclosure may be implemented as follows. The light emitting units, equivalent to the same row, in the two transmitting modules 110 emit light sequentially, and the corresponding detection subunits of the receiving module 120 perform detection respectively. Alternatively, the light emitting units, equivalent to the same row, in the two transmitting modules 110 emit light simultaneously, and one row of detectors, corresponding to the fields of view, of the receiving module 120 are activated to simultaneously receive and detect the reflection echos of the two light emitting units.

According to a preferred embodiment of the present disclosure, the transmitting module 110 in the solid-state LiDAR 100 further includes a transmitting optical component. At least one light emitting unit 111 of the transmitting module 110 is located on the focal plane of the transmitting optical component, and the transmitting optical component is configured to receive the detection beams emitted by the at least one light emitting unit 111, shape the detection beams and then emit the shaped detection beams to the object space.

According to a preferred embodiment of the present disclosure, the transmitting module 110 in the solid-state LiDAR 100 further includes a transmitting lens group corresponding to the laser area array, and the receiving module 120 further includes a receiving lens group corresponding to the detector area array.

According to a preferred embodiment of the present disclosure, as shown in FIG. 4B, multiple lasers of the light emitting unit 111 in the solid-state LiDAR 100 are arranged in a strip shape (as shown in the x direction in FIG. 4B), and the transmitting module 110 includes multiple light emitting units 111 which are arranged in a direction perpendicular to an extension direction of the strip shape (as shown in the y direction in FIG. 4B).

Referring to the label in FIG. 4B, in the two transmitting modules 110, the multiple lasers of the light emitting unit 111 are arranged in the x direction, and the multiple light emitting units 111 are all arranged in the y direction (it is an oblique view in the figure, the actual x direction being perpendicular to the y direction). Preferably, the length of the laser array in the y direction is greater than the length in the x direction.

Returning to the solid-state LiDAR shown in FIG. 1 that only includes one transmitting module, it is assumed that the laser array of the transmitting module is an N×N array. After the solid-state LiDAR is improved by adopting the preferred embodiment of the present disclosure, as shown in FIG. 4B, the solid-state LiDAR 100 includes two transmitting modules 110, the laser arrays of each of the two transmitting modules 110 are N×½N arrays respectively, and one row/column of lasers extending in the ½N direction acts as one light emitting unit and emit light at the same time.

Under the same detection range, the length of the light emitting unit 111 of the transmitting module 110 in the embodiment of FIG. 4B is only half of the length of the light emitting unit of the single-lens solid-state LiDAR in FIG. 1. As such, the length of transmission path of the driving signal of the laser may be reduced. The difference between the driving signal intensities of the lasers at both ends of the transmission path is reduced to effectively reduce the unevenness of the luminous intensities of the lasers at different positions in the light emitting unit.

FIG. 4A and FIG. 4B schematically show that the length of the light emitting unit 111 of the transmitting module 110 is half of the length of the original light emitting unit before improvement. This division manner is just a preferable implementation. The lengths the light emitting units 111 of the multiple transmitting modules 110 may be equal or unequal. For example, the length ratio of the light emitting units 111 of the two transmitting modules 110 is 4:6, 4.5:5.5, or other ratios, which fall within the protection scope of the present disclosure.

According to a preferred embodiment of the present disclosure, the transmitting module 110 is arranged on both sides of the receiving module 120, and the numbers of the transmitting modules 110 located on both sides of the receiving module 120 are the same or different. In order to solve the problem of uneven luminous intensity of the linear light emitting unit in the solid-state LiDAR, in the preferred embodiment provided by the present disclosure, the laser area array in the transmitting module is divided into multiple parts along the arrangement directions of the lasers, which is easily understood for those skilled in the art. Further, it is feasible to further divide the laser area array along the arrangement directions of multiple light emitting units, thereby reducing the area of the laser chip, reducing heat dissipation, and improving yield, which similarly fall within the protection scope of the present disclosure.

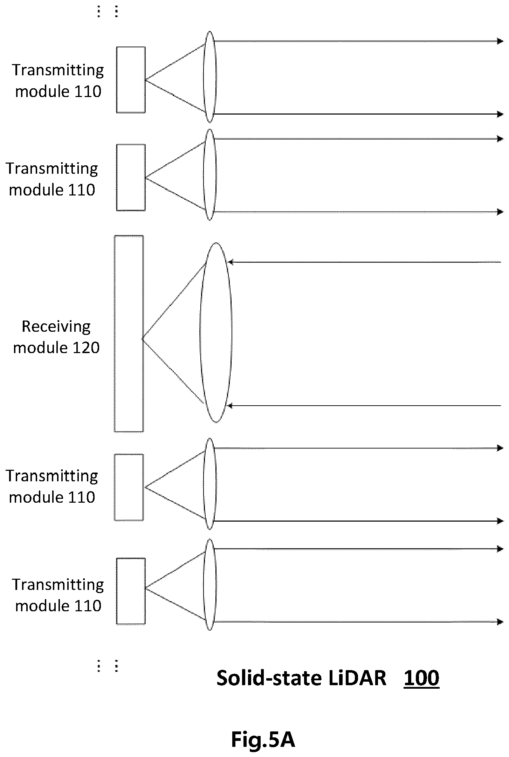

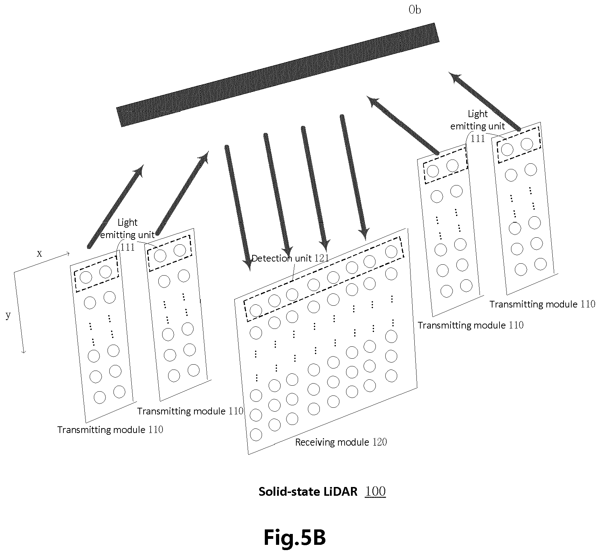

The embodiments of FIG. 4A and FIG. 4B illustrate the case in which the solid-state LiDAR 100 includes two transmitting modules 110. As shown in FIG. 5A, the transmitting module 110 is further divided so that the length of each row of lasers (one light emitting unit) that emits light in parallel is shorter, multiple transmitting modules 110 are arranged around the receiving module 120, and the light emitting units 111 of the multiple transmitting modules 110 are located on the same plane. As shown in FIG. 5B, each transmitting module 110 includes at least one light emitting unit 111, and the light emitting unit 111 includes a plurality of lasers configured to simultaneously emit detection beams. The receiving module 120 includes at least one detection unit 121, and the detection unit 121 includes multiple photodetectors configured to receive echos of the detection beams reflected off the object. Preferably, one detection unit 121 corresponds to one light emitting unit 111 in each transmitting module 110, and the detection unit 121 is configured to receive reflection echos of detection beams emitted by the corresponding multiple light emitting units 111. That is, the technical solution in which the solid-state LiDAR 100 includes a larger number of transmitting modules 110 is encompassed within the protection scope of the present disclosure.

In the embodiment shown in FIG. 5A and FIG. 5B, each transmitting module 110 corresponds to one transmitting optical component. Alternatively, two or more adjacent transmitting modules 110 located on one side of the receiving module 120 may share one transmitting optical component.

According to a preferred embodiment of the present disclosure, each transmitting module 110 in the solid-state LiDAR 100 includes multiple light emitting units 111 of the same number, and the light emitting units 111 corresponding to the same detection unit 121 are located on the same straight line.

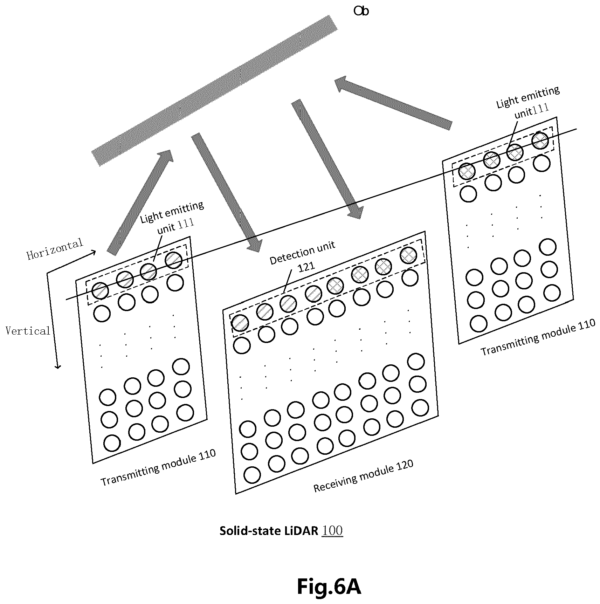

As shown in FIG. 6A, according to a preferred embodiment of the present disclosure, a solid-state LiDAR 100 includes two transmitting modules 110 and one receiving module 120. Each transmitting module 110 includes a plurality of light emitting units 111 of the same number, each receiving module 120 includes a plurality of detection units 121, and each detection unit 121 corresponds to one light emitting unit 111 in each transmitting module 110. The two transmitting modules 110 and one receiving module 120 of the solid-state LiDAR 100 are arranged in the horizontal direction (horizontal direction shown in the figure), and the solid-state LiDAR 100 scans row by row in the vertical direction (vertical direction shown in the figure). The light emitting units 111 corresponding to the same detection unit 121 are located on the same horizontal line (horizontal direction shown in the figure), and the light emitting units 111 corresponding to the same detection unit 121 correspond to the same vertical field of view.

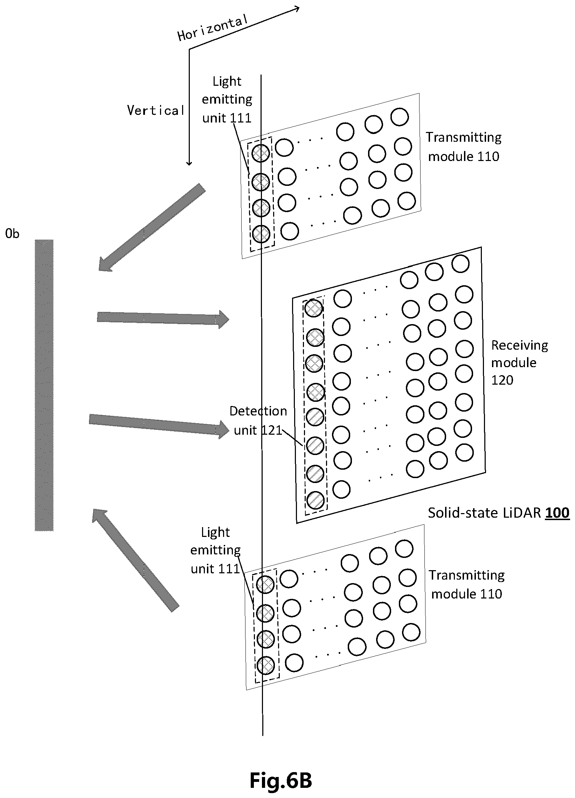

As shown in FIG. 6B, according to a preferred embodiment of the present disclosure, the solid-state LiDAR 100 includes two transmitting modules 110 and one receiving module 120. Each transmitting module 110 includes a plurality of light emitting units 111 of the same number, each receiving module 120 includes a plurality of detection units 121, and each detection unit 121 corresponds to one light emitting unit 111 in each transmitting module 110. The two transmitting modules 110 and one receiving module 120 of the solid-state LiDAR 100 are arranged in the vertical direction (the vertical direction shown in the figure), and the solid-state LiDAR 100 scans column by column in the horizontal direction (the horizontal direction shown in the figure). The light emitting units 111 corresponding to the same detection unit 121 are located on the same vertical line (the vertical direction shown in the figure). Moreover, the light emitting units 111 corresponding to the same detection unit 121 correspond to the same horizontal field of view.

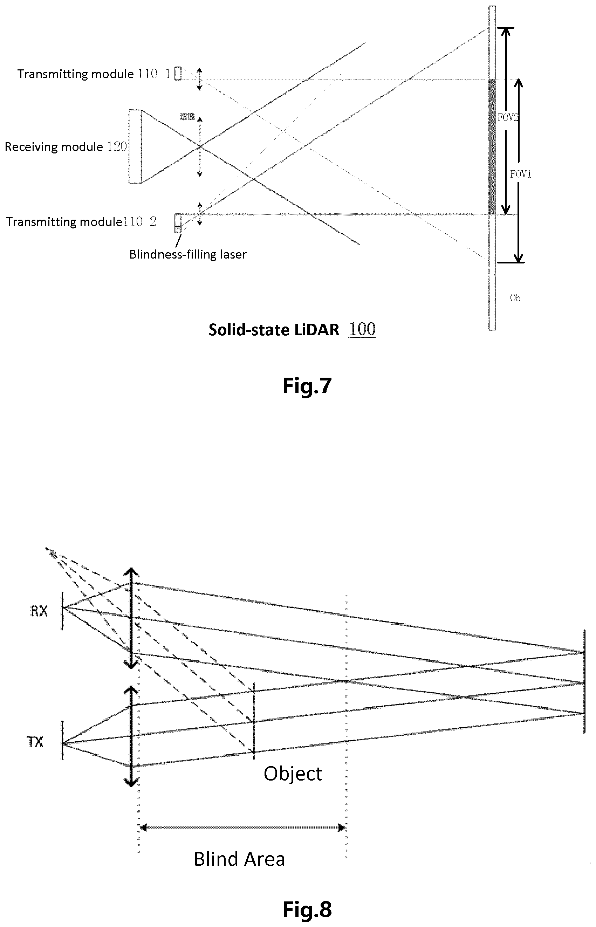

According to a preferred embodiment of the present disclosure, the transreceiver optical path of the solid-state LiDAR 100 is shown in FIG. 7. The light emitted by a laser of the transmitting module 110-1 on a side closest to the receiving module 120 is shaped by the transmitting lens group and then emerges parallel to an optical axis. As the lasers are farther away from the receiving module 120, the emergent beams deflect toward the receiving module 120 sequentially, forming the field of view FOV1 shown in FIG. 7. Similarly, the light emitted by a laser of the transmitting module 110-2 on a side closest to the receiving module 120 is shaped by the transmitting lens group and emerges parallel to the optical axis. As the lasers are farther away from the receiving module 120, the emergent beams deflect toward the receiving module 120 sequentially, forming the field of view FOV2 shown in FIG. 7.

It can be seen that there is a certain overlap between the fields of view of the transmitting module 110-1 and the transmitting module 110-2 (shown by the solid area on ob in FIG. 7). When the light emitting units of the transmitting module 110-1 and the transmitting module 110-2 emit light at the same time, the light intensity of the overlapping area is doubled, which can improve the ranging capability in this area. When the light emitting units of the transmitting module 110-1 and the transmitting module 110-2 do not emit light at the same time, the frequency of detection in this area within a certain time is doubled.

If the transmitting module 110-1, the receiving module 120 and the transmitting module 110-2 are arranged along the vertical direction, there is a certain overlap between the fields of view of the transmitting module 110-1 and the transmitting module 110-2 in the vertical direction. The overlapping area is located in the center of the vertical field of view of the LiDAR. The vehicle-mounted LiDAR mainly detects a pedestrian and a vehicle on the ground, and the object is concentrated in the center of the vertical field of view. The above-mentioned embodiments can improve the ranging capability or detection frequency in the central area, and are more suitable for the application scenarios of the vehicle-mounted LiDAR.

If the transmitting module 110-1, the receiving module 120 and the transmitting module 110-2 are arranged along the horizontal direction, there is a certain overlap between the fields of view of the transmitting module 110-1 and the transmitting module 110-2 in the horizontal direction. The overlapping area is located at the center of the horizontal field of view of the LiDAR, that is, directly in front of the LiDAR. The above embodiments can improve the ranging capability or detection frequency in the LiDAR's forward-facing area.

The preferred embodiment of the present disclosure provides a solid-state LiDAR. For a set range of field of view, the lengths of the linear light emitting units that emit light at the same time are greatly reduced by setting a plurality of transmitting modules, thereby greatly reducing the unevenness of light emission of the light emitting units, reducing the ranging error of the solid-state LiDAR within the set field of view, and improving the ranging performance.

In the preferred embodiment of the present disclosure, the number of lasers emitting light at the same time is decreased, the emission power of a single light emitting unit is reduced, the heat dissipation of the emission end can be reduced, and the temperature fluctuation can be lowered.

In a preferred embodiment of the present disclosure, when the light emitting units corresponding to multiple transmitting modules do not emit light at the same time, the emission power of a single light emission can be reduced, which is beneficial to the safety of human eyes. On the premise of meeting the safety requirements of human eyes, since the number of lasers emitting light at the same time is reduced, the laser power can be increased. Consequently, the optical power of detection light can be improved, and the ranging capability of the LiDAR can be enhanced. In addition, the number of detectors performing simultaneous detection is correspondingly reduced, which can reduce signal crosstalk among multiple detectors.

In a preferred embodiment of the present disclosure, after the detection light emitted by multiple transmitting modules is shaped and emerges, there is a certain overlapping area in the central field of view, which can increase the detection precision in the central area.

In a preferred embodiment of the present disclosure, the lengths of the linear light emitting units in some of the transmitting modules can be appropriately extended, thereby effectively reducing the blind area of the solid-state LiDAR. No special design is required for the laser area array, and there is no increase in the complexity of design and process.

According to a preferred embodiment of the present disclosure, in the solid-state LiDAR 100, a blindness-filling laser is arranged on a side of the light emitting unit 111 away from the receiving module 120 in the extension direction of the strip shape, and the detection range of the blindness-filling laser is different from that of the light emitting unit 111. The echo of the detection light emitted by the blindness-filling laser and reflected off the object can be received by the detection unit 121 corresponding to the light emitting unit 111.

A near-far effect occurs in the paraxial LiDAR. That is, as the distance from the object changes, the spot of the echo beam on a photosensitive surface will move. As shown in FIG. 8, when the distance from the object is reduced to a critical distance, the spot will move out of the photosensitive surface of the area array detector and cannot be detected by the LiDAR. That is, the area where the light of the transmitting module TX and the light of the receiving module RX in FIG. 8 do not overlap is the blind area of the LiDAR. For an object in the blind area, the image point formed by the reflection echo light through the receiving lens is not on the focal plane of the receiving lens (where the area array detector of the receiving module RX is located in the figure), but behind the focal plane. In addition, in the viewing angle of FIG. 8, the short-distance object is below the optical axis of the receiving lens, so the image point formed by it through the receiving lens must be above the optical axis of the receiving lens. Taking these two aspects into consideration, the position of the focal point of the reflection light from the short-distance object relative to the receiving module RX is shown in FIG. 8. In the short-range blind area of the LiDAR, the receiving module RX of the LiDAR cannot receive the reflection signal from the object at all.

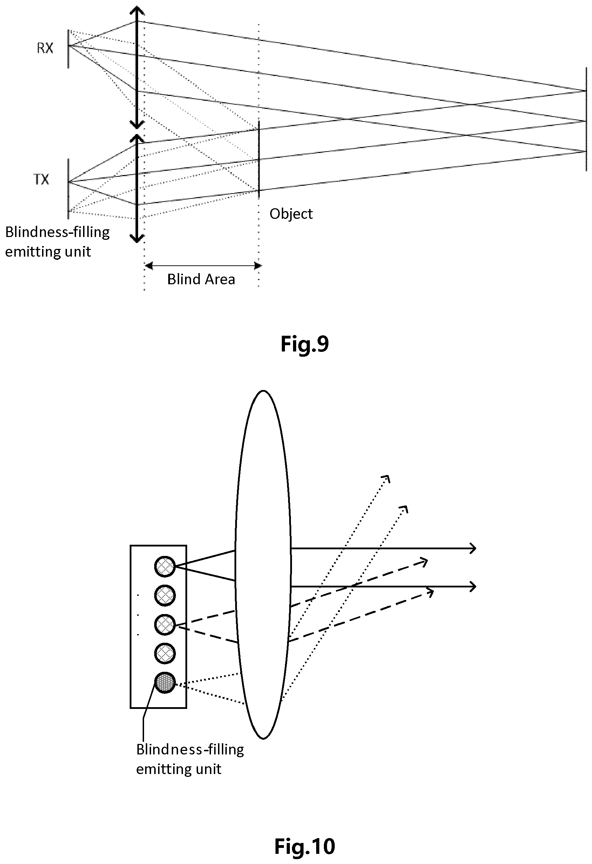

The present disclosure provides a solution for reducing the blind area. As shown in FIG. 9, the transmitting module TX is provided with a blindness-filling laser. The blindness-filling laser is on a side of the transmitting module TX away from the receiving module RX, and the detection light is deflected to the blind area after passing through the transmitting lens and is used for supplementary detection of the blind area. The transmitting module TX is arranged in the focal plane of the transmitting optical component. Multiple lasers are in different positions of the focal plane, and the emitted light therefrom is deflected in different directions after being collimated by the transmitting optical component. In the solid-state LiDAR 100 shown in FIG. 7 above, a blindness-filling laser is also provided on a side of the transmitting module TX2 away from the receiving module RX, and the optical path thereof is shown in FIG. 7 along the detection beam emitted by the blindness-filling laser.

As shown in FIG. 10, the blindness-filling laser is set on a side of the light emitting unit farthest away from the optical axis of the transmitting optical component in the direction of the strip-shaped arrangement, and an angle between an emergence direction of the beam emitted therefrom after being shaped and collimated by the transmitting optical component and the optical axis is the largest, forming a blindness-filling detection light. For the far-field echo, the echo spot of the blindness-filling laser will be focused outside the area array detector and cannot be detected. As the distance from the object decreases, the echo spot offsets toward the RX direction as shown in FIG. 9 and fall on the RX detector. At this time, the echo of the blindness-filling laser from the short-range object can be received by the detector due to the upward offset, thereby reducing the blind area of the LiDAR.

As another preferred solution, in FIG. 7, a side of the transmitting module TX1 away from the receiving module RX may also be provided with a blindness-filling laser to further reduce the range of the blind area.

In combination with FIGs. 7, 8, 9 and 10, the provision of the blindness-filling laser is equivalent to adding a certain length in the extension direction of the linear light emitting unit, that is, adding a certain number of lasers without changing the arrangement of the lasers. The implementation is simple and has a low cost. The number of lasers increased to reduce the blind area can be obtained by calculating the optical path according to the optical design.

According to a preferred embodiment of the present disclosure, the transmitting module 110 in the solid-state LiDAR 100 further includes an electrode unit, which is electrically connected to a plurality of lasers of the light emitting unit 111. The electrode unit includes a plurality of driving terminals, through which driving signals may be loaded into multiple lasers of the light emitting unit 111 at the same time.

Preferably, the electrode unit further includes pads disposed at both ends of the light emitting unit 111 in the extension direction of the strip shape, and the pads are used for loading the driving signals.

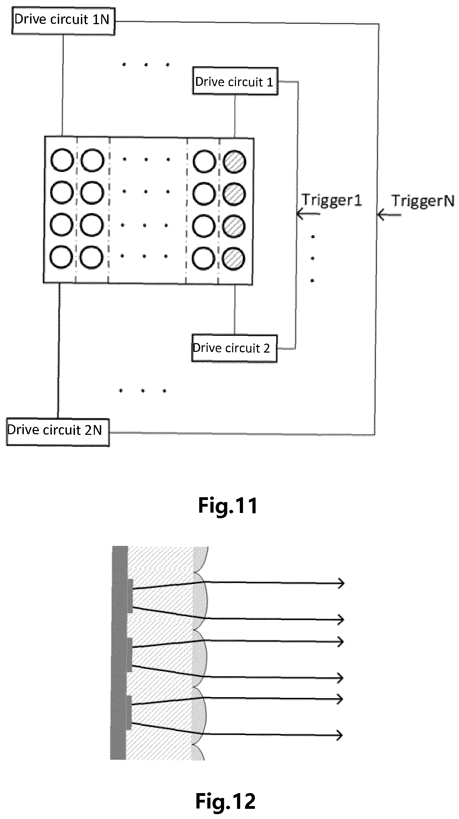

In order to further reduce the non-uniformity of light emission of the linear light emitting unit, the present disclosure adopts double-side driving for the linear light emitting unit. Unlike the existing technology shown in FIG. 2 where the driving signals are feed into the pads on one side of the linear light emitting unit, the pads are respectively disposed at two sides of the linear light emitting unit in the extension direction of the strip shape and are connected to the drive circuits respectively, and the two drive circuits connected to the same light emitting unit are controlled by the same emission control signal to turn on the drive switches simultaneously, as shown in FIG. 11, in accordance with a preferred embodiment of the present disclosure. Driving signals are imultaneously injected from both ends of the same light emitting unit. As shown in FIG. 11, drive circuit 1 and drive circuit 2 respectively generate driving signal components that act on the same laser, and the two driving signal components are superimposed to form a driving signal for controlling the light emission of a laser. Therefore, one driving signal component can compensate the attenuation of the driving line suffered by the other driving signal component, so that the difference of the driving currents flowing through the multiple lasers on the driving line is smaller, and the unevenness of light emission is further reduced.

According to a preferred embodiment of the present disclosure, the transmitting module 110 in the solid-state LiDAR 100 further includes a microlens array, which is arranged downstream of the optical paths of the multiple lasers.

The laser array can be used in conjunction with the microlens array, as shown in FIG. 12. The microlens array is fixed in front of the laser array. Alternatively, the substrate of the laser chip is prepared as a microlens array, and the beam emitted by the laser is collimated to improve the beam quality.

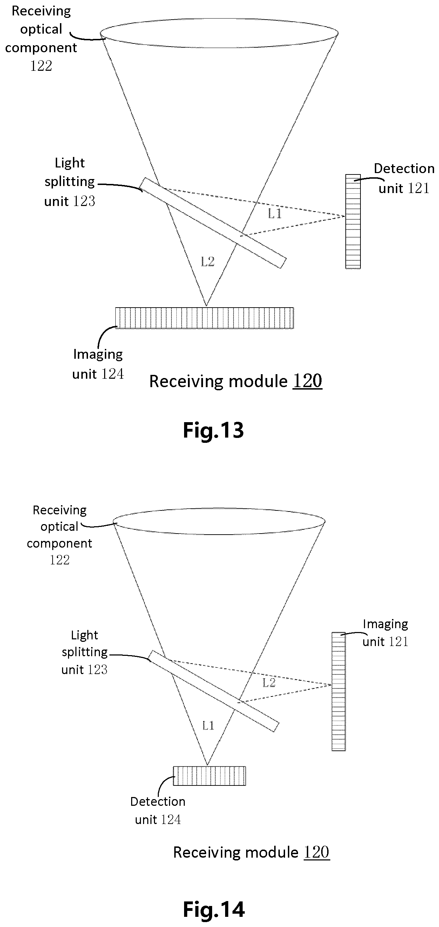

According to a preferred embodiment of the present disclosure, as shown in FIG. 13, the receiving module 120 in the solid-state LiDAR 100 further includes: a receiving optical component 122, a light splitting unit 123, at least one detection unit 121 and at least one imaging unit 124.

The receiving optical component 122 is configured to receive and converge echos L1 of the detection beams of a first band emitted by the solid-state LiDAR 100 and reflected off the object, and beams L2 of a second band, wherein the second band does not include the first band. Preferably, the receiving optical component 11 has no wavelength selectivity, and beams of both infrared and visible bands can pass through it without distinction. The light splitting unit 123 is disposed downstream of an optical path of the receiving optical component 122 and is configured to separate the optical paths of the reflection echos L1 of the detection beams from the optical paths of the beams L2 of the second band. At least one detection unit 121 is disposed downstream of the optical path of the light splitting unit 123 and is configured to receive the reflection echos L1 of the detection beams from the light splitting unit 123 and convert the reflection echos L1 of the detection beams into electrical signals. At least one imaging unit 124 is disposed downstream of the optical path of the light splitting unit 123 and is configured to receive the beams L2 of the second band from the light splitting unit 123and form an image.

According to a preferred embodiment of the present disclosure, a plurality of photodetectors of each detection unit 121 in the solid-state LiDAR 100 are simultaneously activated to receive reflection echos L1, each imaging unit 124 includes a plurality of image sensors, and the plurality of image sensors of each imaging unit 124 are simultaneously activated to receive the beams L2 of the second band and form an image. The detection unit 121 and the imaging unit 124 corresponding to the same field of view are simultaneously activated for detection and exposure.

According to a preferred embodiment of the present disclosure, the light splitting unit 123 in the solid-state LiDAR 100 includes a light splitting transflective mirror, such that the reflection echos of the detection beams are reflected, and the beams of the second band are transmitted, or alternatively, the reflection echos of the detection beams are transmitted, and the beams of the second band are reflected.

As shown in FIG. 13, the wavelength splitting transflective mirror is used as the light splitting unit 123. Taking the detection light with a wavelength of 940nm as an example, a highly reflective film of 940nm is coated on the surface of the wavelength splitting transflective mirror so that the laser light in the 940nm band is reflected, and at least one detection unit 121 is arranged on the focal plane where the reflected beams converge. The light of other bands can be transmitted therethrough and converged onto at least one imaging unit 124 at the focal plane position.

As shown in FIG. 14, a dichroic coating is coated on the surface of the wavelength splitting transflective mirror so that the echo beams of 940nm are transmitted therethrough and received by the detection unit 121 for distance detection. The light of other bands is reflected onto the imaging unit 124 for imaging.

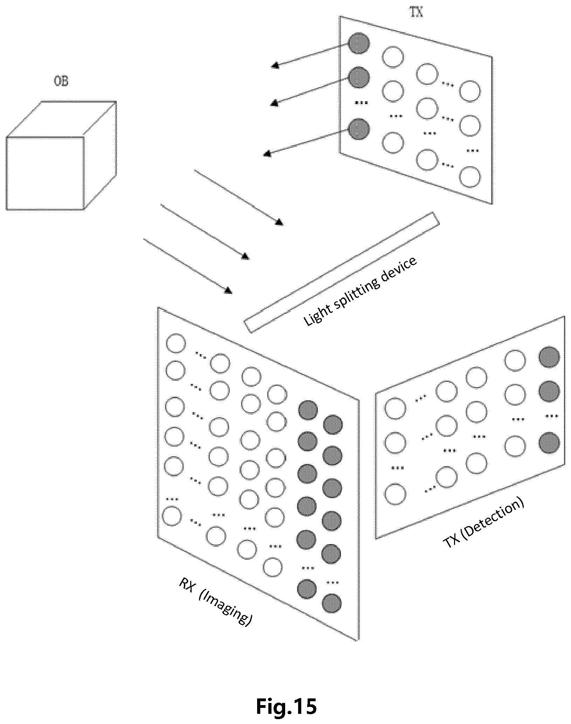

According to a preferred embodiment of the present disclosure, as shown in FIG. 15, the receiving module RX includes a distance sensor array and an image sensor array (such as a CMOS array with an RGGB filter), and a light splitting device is disposed in the receiving optical path. The beams converged by the receiving lens group are divided into two parts by the light splitting device: detection band light and other band light. The detection band light is the echo light of the detection light emitted by the transmitting module TX and reflected off the object, which is received by the distance sensor array of the receiving module RX for echo signal detection. The other band light is received by the image sensor array of the receiving module RX to obtain a color image. Both the distance sensor array and the image sensor array of the receiving module RX are arranged in the focal plane of the receiving lens group, and the light splitting element separates the detection band light from other band light and irradiates them onto different sensors.

The preferred embodiment of the present disclosure adopts two transmitting modules, does not need to change the design of the detector array of the receiving module, and is easy to combine with the scheme of the light splitting element+SPAD/CMOS array. In the full measurement range, the two sensor arrays can sense the exact same object at the same time, and substantially no registration of physical location is required for the results of the two sensors. Further, the depth information and the color image are obtained at the same time, the algorithm is simple, and the two sensor arrays share the receiving optical component, which greatly reduces the cost of production, assembly and adjustment.

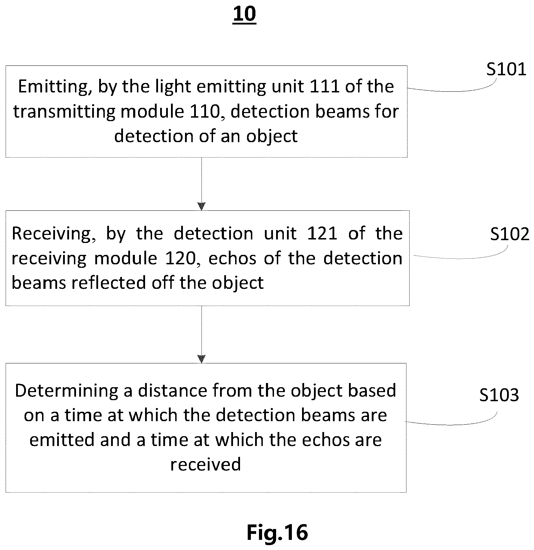

According to a preferred embodiment of the present disclosure, as shown in FIG. 16, the present disclosure further provides a method 10 for detection using the solid-state LiDAR 100 as described above, including:
in step S101, emitting, by the light emitting unit 111 of the transmitting module 110, detection beams for detection of an object;
in step S102, receiving, by the detection unit 121 of the receiving module 120, echos of the detection beams reflected off the object; and
in step S103, determining a distance from the object based on a time at which the detection beams are emitted and a time at which the echos are received.

According to a preferred embodiment of the present disclosure, the solid-state LiDAR 100 includes two transmitting modules 110, the two transmitting modules 110 are located on both sides of the receiving module 120, the two transmitting modules 110 each include a plurality of light emitting units 111 of the same number, and the light emitting units 111 corresponding to the same detection unit 121 are located on the same straight line. The detection method 10 further includes:
emitting light simultaneously or alternately by two light emitting units 111 corresponding to the same detection unit 121.

According to a preferred embodiment of the present disclosure, the plurality of lasers of the light emitting unit 111 are arranged in a strip shape, a blindness-filling laser is provided on a side of the light emitting unit 111 away from the receiving module 120 in the extention direction of the strip shape, a detection range of the blindness-filling laser is different from that of the light emitting unit 111, and an echo of detection light emitted by the blindness-filling laser and reflected off the object can be received by the detection unit 121 corresponding to the light emitting unit 111. The detection method 10 further includes: emitting light simultaneously by the blindness-filling laser and the light emitting unit 111.

According to a preferred embodiment of the present disclosure, the plurality of lasers of the light emitting unit 111 are arranged in a strip shape, the transmitting module 110 further includes an electrode unit electrically connected to the plurality of lasers of the light emitting unit 111, and the electrode unit includes a plurality of driving terminals. The detection method 10 further includes:
simultaneously loading driving signals to the plurality of lasers of the light emitting unit 111 through the plurality of driving terminals.

According to a preferred embodiment of the present disclosure, the electrode unit further includes pads provided at both ends of the light emitting unit 111 in an extension direction of the strip shape. The detection method 10 further includes:
loading the driving signals via the pads.

According to a preferred embodiment of the present disclosure, the receiving module 120 further includes: a receiving optical component; a light splitting unit arranged downstream of an optical path of the receiving optical component; the at least one detection unit arranged downstream of an optical path of the light splitting unit; and at least one imaging unit arranged downstream of the optical path of the light splitting unit. The detection method 10 further includes:
receiving and converging, by the receiving optical component, echos of the detection beams of a first band emitted by the solid-state LiDAR and reflected off the object, and beams of a second band, wherein the second band does not include the first band;
separating, by the light splitting unit, optical paths of the reflection echos of the detection beams from optical paths of the beams of the second band;
receiving the reflection echos of the detection beams from the light splitting unit and converting the reflection echos of the detection beams into electrical signals by the at least one detection unit; and
receiving the beams of the second band from the light splitting unit and forming an image by the at least one imaging unit.

The detection method 10 provided by the present disclosure and its technical effects have already been set forth in the discussion of the solid-state LiDAR 100 provided by the present disclosure, and will not be repeated here.

It should be noted finally that the contents described above are only preferred embodiments of the present disclosure, and are not used to limit the present disclosure. Although the detailed description of the present disclosure has been provided with reference to the foregoing embodiments, those skilled in the art may still make modifications to the technical solution as recited in each of the foregoing embodiments, or make equivalent replacements for some of the technical features therein. Any modification, equivalent replacement, or improvement, etc., made within the spirit and principles of the present disclosure, should be included in the protection scope of the present disclosure.

## Claims

1. A solid-state LiDAR, comprising:
a plurality of transmitting modules, each of which comprises at least one light emitting unit, the light emitting unit comprising a plurality of lasers configured to simultaneously emit detection beams; and
a receiving module comprising at least one detection unit, the detection unit comprising a plurality of photodetectors,
wherein the plurality of transmitting modules are arranged around the receiving module, the light emitting units of the plurality of transmitting modules are located on a same plane, and one detection unit is configured to receive echos of the detection beams emitted from the light emitting units of the plurality of transmitting modules and reflected off an object.

2. The solid-state LiDAR according to claim 1, wherein the plurality of lasers of the light emitting unit are arranged along a strip shape, and the transmitting module comprises a plurality of light emitting units that are arranged in a direction perpendicular to an extention direction of the strip shape.

3. The solid-state LiDAR according to claim 1, wherein the transmitting modules are arranged on both sides of the receiving module, and the numbers of transmitting modules on both sides of the receiving module are the same or different.

4. The solid-state LiDAR according to claim 3, wherein each of the transmitting modules comprises a plurality of light emitting units of a same number, and light emitting units corresponding to a same detection unit are located on a same straight line.

5. The solid-state LiDAR according to claim 4, wherein fields of view corresponding to a plurality of light emitting units located on the same straight line partially overlap.

6. The solid-state LiDAR according to any one of claims 1-5, wherein the solid-state LiDAR comprises two transmitting modules, and the two transmitting modules are located on both sides of the receiving module.

7. The solid-state LiDAR according to any one of claims 1-5, wherein the light emitting unit comprises a VCSEL array, and the detection unit comprises a SPAD array.

8. The solid-state LiDAR according to claim 2, wherein a blindness-filling laser is provided on a side of the light emitting unit away from the receiving module in the extention direction of the strip shape, a detection range of the blindness-filling laser is different from that of the light emitting unit, and an echo of detection light emitted by the blindness-filling laser and reflected off the object can be received by the detection unit corresponding to the light emitting unit.

9. The solid-state LiDAR according to claim 2, wherein the transmitting module further comprises an electrode unit, the electrode unit is electrically connected to the plurality of lasers of the light emitting unit, and the electrode unit comprises a plurality of driving terminals, through which driving signals are simultaneously loaded to the plurality of lasers of the light emitting unit.

10. The solid-state LiDAR according to claim 9, wherein the electrode unit further comprises pads disposed at both ends of the light emitting unit in the extention direction of the strip shape, and the pads are used to load the driving signals.

11. The solid-state LiDAR according to any one of claims 1-5, wherein the transmitting module further comprises a transmitting optical component, at least one light emitting unit of the transmitting module is located on a focal plane of the transmitting optical component, and the transmitting optical component is configured to receive the detection beams emitted by the at least one light emitting unit, shape the detection beams and then emit the shaped detection beams to an object space.

12. The solid-state LiDAR according to claim 11, wherein the transmitting optical components of the plurality of transmitting modules are identical.

13. The solid-state LiDAR according to any one of claims 1-5, wherein the transmitting module further comprises a microlens array disposed downstream of optical paths of the plurality of lasers.

14. The solid-state LiDAR according to any one of claims 1-5, wherein the receiving module further comprises:
a receiving optical component configured to receive and converge echos of the detection beams of a first band emitted by the solid-state LiDAR and reflected off the object, and beams of a second band, wherein the second band does not comprise the first band;
a light splitting unit arranged downstream of an optical path of the receiving optical component and configured to separate optical paths of reflection echos of the detection beams from optical paths of the beams of the second band;
the at least one detection unit arranged downstream of an optical path of the light splitting unit and configured to receive the reflection echos of the detection beams from the light splitting unit and convert the reflection echos of the detection beams into electrical signals; and
at least one imaging unit arranged downstream of the optical path of the light splitting unit and configured to receive the beams of the second band from the light splitting unit and form an image.

15. The solid-state LiDAR according to claim 14, wherein the plurality of photodetectors of each detection unit are simultaneously activated to receive the reflection echos, each imaging unit comprises a plurality of image sensors, the plurality of image sensors of the imaging unit are simultaneously activated to receive the beams of the second band and form an image, and a detection unit and an imaging unit corresponding to a same field of view are simultaneously activated for detection and exposure.

16. The solid-state LiDAR according to claim 14 or 15, wherein the light splitting unit comprises a light-splitting transflective mirror, such that the reflection echos of the detection beams are reflected, and the beams of the second band are transmitted, or alternatively, the reflection echos of the detection beams are transmitted, and the beams of the second band are reflected.

17. A method for detection using the solid-state LiDAR according to any one of claims 1-16, comprising:
emitting, by the light emitting units of the transmitting modules, detection beams for detection of an object;
receiving, by the detection unit of the receiving module, echos of the detection beams reflected off the object; and
determining a distance from the object based on a time at which the detection beams are emitted and a time at which the echos are received.

18. The method according to claim 17, wherein the solid-state LiDAR comprises two transmitting modules, the two transmitting modules are located on both sides of the receiving module, the two transmitting modules each comprise a plurality of light emitting units of a same number, and light emitting units corresponding to a same detection unit are located on a same straight line, and the method further comprises:
emitting light simultaneously or alternately by two light emitting units corresponding to the same detection unit.

19. The method according to claim 17 or 18, wherein the plurality of lasers of the light emitting unit are arranged in a strip shape, a blindness-filling laser is provided on a side of the light emitting unit away from the receiving module in an extention direction of the strip shape, a detection range of the blindness-filling laser is different from that of the light emitting unit, and an echo of detection light emitted by the blindness-filling laser and reflected off the object is receivable by the detection unit corresponding to the light emitting unit; and the method further comprises: emitting light simultaneously by the blindness-filling laser and the light emitting unit.

20. The method according to claim 17 or 18, wherein the plurality of lasers of the light emitting unit are arranged in a strip shape, the transmitting module further comprises an electrode unit electrically connected to the plurality of lasers of the light emitting unit, and the electrode unit comprises a plurality of driving terminals; and the method further comprises:
simultaneously loading driving signals to the plurality of lasers of the light emitting unit through the plurality of driving terminals.

21. The method according to claim 20, wherein the electrode unit further comprises pads provided at both ends of the light emitting unit in an extension direction of the strip shape, and the method further comprises:
loading the driving signals via the pads.

22. The method according to claim 17 or 18, wherein the receiving module further comprises: a receiving optical component; a light splitting unit arranged downstream of an optical path of the receiving optical component; the at least one detection unit arranged downstream of an optical path of the light splitting unit; and at least one imaging unit arranged downstream of the optical path of the light splitting unit; and the method further comprises:
receiving and converging, by the receiving optical component, echos of the detection beams of a first band emitted by the solid-state LiDAR and reflected off the object, and beams of a second band, wherein the second band does not comprise the first band;
separating, by the light splitting unit, optical paths of reflection echos of the detection beams from optical paths of the beams of the second band;
receiving the reflection echos of the detection beams from the light splitting unit and converting the reflection echos of the detection beams into electrical signals by the at least one detection unit; and
receiving the beams of the second band from the light splitting unit and forming an image by the at least one imaging unit.
